# EUROPÄISCHE PATENTANMELDUNG

(11) **EP 1 061 160 A1**
(43) Veröffentlichungstag der Anmeldung: **20.12.2000**
(21) Anmeldenummer: 00111086.5
(22) Anmeldetag: 05.06.2000
(51) Int. Cl.: C30B 15/00, C30B 29/06, C30B 15/34

(54) **Silicium mit struktierter Sauerstoffdotierung, dessen Herstellung und Verwendung**

(30) Priorität: 17.06.1999 DE 19927604
(71) Anmelder: Bayer Aktiengesellschaft, 51368 Leverkusen (DE)
(72) Erfinder: Hässler, Christian, Dr., 47800 Krefeld (DE); Höfs, Hans-Ulrich, Dr., 47829 Krefeld (DE); Koch, Wolfgang, Dr., 47809 Krefeld (DE); Thurm, Siegfried, Dr., 40668 Meerbusch (DE); Breitenstein, Otwin, Dr., 06179 Langenbogen (DE)

(57) **Zusammenfassung**

Die vorliegende Erfindung betrifft Silicium mit einem hohen Sauerstoffgehalt und zugleich einer hohen Dichte an Kristallgitterversetzungen und dessen Herstellung. Dieses Silicium kann in der Photovoltaik eingesetzt werden. Solarzellen, die auf dem erfindungsgemäßen Material basieren, weisen trotz des hohen Sauerstoffgehalts gute Wirkungsgrade auf.

## Beschreibung

Die vorliegende Erfindung betrifft Silicium mit einem hohen Sauerstoffgehalt und einer hohen Dichte an Versetzungen, dessen Herstellung und dessen Verwendung für die Herstellung von Solarzellen.

Kristallines Silicium ist das Material, aus dem gegenwärtig der überwiegende Anteil aller Solarzellen zur photovoltaischen Umwandlung von Sonnenlicht in elektrische Energie gefertigt wird. Dabei bilden monokristallines und multikristallines Silicium die beiden hauptsächlichen Varianten des für Solarzellen verwendeten Siliciummaterials. Während monokristallines Silicium üblicherweise nach dem Czochralski-Verfahren als Einkristall aus einer Silicium-Schmelze gezogen wird, gibt es für multikristallines Silicium mehrere Herstellungsverfahren. Die gebräuchlichsten Verfahren sind verschiedene Blockkristallisationsverfahren, bei denen die Silicium-scheiben für die Solarzellherstellung durch Zersägen eines massiven multikristallinen Silicium-Blocks gewonnen werden, und verschiedene Folienziehverfahren bzw. Foliengießverfahren, bei denen die Scheiben in ihrer fertigen Dicke als eine Silicium-Folie aus einer Schmelze gezogen bzw. gegossen werden. Beispiele für das Folienziehverfahren sind das EFG-Verfahren (Edge-defined Film-fed Growth) (EP 0 369 574 A2) und das RGS-Verfahren (EP 0 165 449 A1, DE 41 02 484 A1, DE 41 05 910 A1).

Solarzellen sind großflächige pn-Dioden, in deren Volumen durch das Sonnenlicht Minoritätsladungsträger erzeugt werden, die zum Emitter an der Oberfläche der Zelle diffundieren müssen, um dort am pn-Übergang durch das elektrische Feld getrennt zu werden und zu dem äußeren Stromfluss beizutragen. Dies geschieht um so effektiver, je größer die Lebensdauer und damit auch die Diffusionslänge der Minoritätsladungsträger in der Basis ist. Daraus ergeben sich besondere Anforderungen an die Qualität des Siliciummaterials zur Herstellung von Solarzellen: Dieses Material muss möglichst frei von Verunreinigungen und Kristalldefekten sein, um eine maximale Diffusionslänge der Minoritätsladungsträger zu ermöglichen.

Sauerstoff ist üblicherweise die dominierende Verunreinigung in Silicium, da die Silicium-Schmelze meistens in einem Quarz-Tiegel (SiO₂) aufgeschmolzen wird. Obwohl Sauerstoff als interstitiell gelöste Verunreinigung elektrisch inaktiv ist, ist doch bekannt, dass es bei Vorliegen eines Sauerstoffgehaltes oberhalb von circa 8×10¹⁷ Atomen/cm³ im Silicium-Material durch Hochtemperaturschritte ebenfalls zur Erniedrigung der Minoritätsträgerlebensdauer (J. Vanhellemont et al., J. Appl. Phys. 77 (11), 5669 (1995)) und damit auch des Wirkungsgrads von Solarzellen kommt. Deshalb galt bisher die Regel, dass Silicium-Material mit einem Sauerstoffgehalt oberhalb von 8×10¹⁷ Atomen/cm³ für die Produktion von Solarzellen ungeeignet ist.

Gerade für sehr produktive Folienzieh- bzw. Foliengießverfahren ist es besonders schwierig und aufwendig, ein Siliciummaterial mit einem genügend niedrigen Sauerstoffgehalt zu erzeugen. Insbesondere beim RGS-Material ist für die Einstellung einer hinreichend glatten Oberfläche eine Begasung der erstarrenden Oberfläche mit einem oxidierenden Gas erforderlich (DE 41 05 910 A1). So stellt sich beim RGS-Material eine relativ hohe Sauerstoffkonzentration im Volumen ein. In der oberflächennahen Siliciumschicht ist der Sauerstoffgehalt noch größer, ja die Oberfläche der unbehandelten Proben ist zu großen Teilen sogar mit einer Siliciumdioxidschicht bedeckt. Dies ist zur Immobilisierung aussegregierter Verunreinigungen notwendig und erwünscht. Bei den dünnen Siliciumfolien, eine RGS-Folie hat eine Dicke von rund 300 µm, würden ohne die getternde Wirkung des oberflächennahen Sauerstoffs die soeben in dieser dünnen Zone angereicherten metallischen Verunreinigungen umgehend in das noch über 1000°C heiße Folieninnere zurückdiffundieren.

Der Erfindung liegt die Aufgabe zugrunde, Silicium bereitzustellen, das trotz einer hohen Sauerstoffkonzentration für eine Verwendung in der Photovoltaik geeignet ist, d.h. dass Solarzellen, die dieses Silicium enthalten, Wirkungsgrade erreichen, die einen wirtschaftlich sinnvollen Einsatz ermöglichen.

Es wurde nun gefunden, dass Silicium mit einer hohen Sauerstoffkonzentration in der Photovoltaik eingesetzt werden kann, wenn es zusätzlich eine hohe Dichte an Kristallgitterversetzungen (im Folgenden Versetzungen genannt) aufweist. Dies ist um so überraschender, als eine hohe Dichte an Versetzungen in der Regel zu Materialien führt, die für die Photovoltaik wenig geeignet sind.

Die Erfindung betrifft demnach Silicium das einen Gesamtsauerstoffgehalt von 8x10¹⁷ Atomen/cm³ bis 1x10¹⁹ Atomen/cm³ und eine Dichte an Versetzungen von 1x10⁵ cm⁻² bis 5x10⁷ cm⁻² aufweist. Vorzugsweise beträgt die Dichte an Versetzungen 5x10⁵ cm⁻² bis 5x10⁶ cm⁻².

Ferner betrifft die Erfindung ein Verfahren zur Herstellung von Silicium mit einem Gesamtsauerstoffgehalt von 8x10¹⁷ Atomen/cm³ bis 1x10¹⁹ Atomen/cm³ und einer Dichte an Versetzungen von 1x10⁵ cm⁻² bis 5x10⁷ cm⁻² und Solarzellen, die dieses Silicium enthalten.

Das erfindungsgemäße Silicium kann mit sehr produktiven Verfahren, beispielsweise Foliengieß- bzw. Folienziehverfahren kostengünstig hergestellt und vorteilhaft in der Photovoltaik eingesetzt werden. Solarzellen, die das erfindungsgemäße Silicium enthalten, weisen teilweise einen höheren Kurzschlussstrom auf, als eine identisch prozessierte Solarzelle, die auf monokristallinem Czochralski-Silicium basiert, einem besonders hochwertigen Material für die Photovoltaik.

Der hohe Sauerstoffgehalt des erfindungsgemäßen Siliciums kann dabei beispielsweise dadurch erreicht werden, dass flüssiges Silicium während des Kristallisationsprozesses mit einem sauerstoffhaltigem Gas oder Gasgemisch begast wird. Vorteilhafterweise wird mit einem Gasgemisch begast, das aus einer Inertgaskomponente und einer Reaktivgaskomponente besteht. Als Inertgaskomponente sei Argon genannt, als Reaktivgaskomponente Sauerstoff. Der hohe Sauerstoffgehalt kann beispielsweise auch durch die gezielte Verwendung von Quarz(SiO₂)-Tiegeln und -Einbauten mit einem hohen Verhältnis von Oberfläche dieser Quarzteile, die während der Herstellung des Siliciummaterials von flüssigem Silicium benetzt ist, zum Volumen des flüssigen Siliciums eingestellt werden. Eine Kombination mehrerer Methoden ist vorteilhaft. Besonders vorteilhaft lässt sich ein hoher Sauerstoffgehalt erreichen, indem das Silicium nach dem RGS-Verfahren hergestellt wird, wie es beispielsweise in DE 4105910 A1 beschrieben wird, und dabei einem Gasgemisch ausgesetzt wird, das mindestens 50 Vol.% Sauerstoff enthält.

Die Dichte an Versetzungen wird über die Kristallisationsgeschwindigkeit bei der Herstellung des Siliciums eingestellt. Hohe Kristallisationsgeschwindigkeiten haben üblicherweise hohe Kristalldefekt- und damit Versetzungsdichten zur Folge. Die Kristallisationsgeschwindigkeit ihrerseits wird durch die Temperaturführung während des Kristallisationsprozesses von flüssigem Silicium eingestellt. Ein schnelles Abkühlen von flüssigem Silicium bedingt eine hohe Kristallisationsgeschwindigkeit und damit eine hohe Versetzungsdichte. Ein schnelles Abkühlen des soeben kristallisierten Siliciums ist in der Regel mit steilen Temperaturgradienten verbunden; diese haben mechanische Spannungen zur Folge, die wiederum die Bildung weiterer Versetzungen bewirken.

Erfindungsgemäß lässt sich durch eine geeignete Temperaturführung auch beeinflussen, in welcher Form der Sauerstoff im Silicium vorliegt. Für den Einsatz des Siliciums in der Photovoltaik ist es vorteilhaft, wenn mindestens 25 %, vorzugsweise mindestens 50 %, besonders bevorzugt mindestens 75 % des gesamten vorhandenen Sauerstoffs in Form von Silicium-Sauerstoff-Ausscheidungen vorliegt, während der restliche Sauerstoff als interstitieller (gelöster) Sauerstoff im Silicium verteilt ist. Dies wird beispielsweise dadurch erreicht, dass für einen Zeitraum von 1 Minute bis 10 Stunden, vorzugsweise von 15 Minuten bis 2 Stunden auf eine Temperatur von 500°C bis 1250°C, vorzugsweise von 800°C bis 1150°C erhitzt wird, wobei die Temperatur jedoch mindestens 1 Minute 950°C übersteigt. Die Temperatur kann im angegebenen Bereich konstant gehalten oder variiert werden. Anschließend lässt man das Silicium auf Raumtemperatur abkühlen.

Der Gehalt an gelöstem (interstitiellem) Sauerstoff wird per FTIR nach DIN 50 438 Teil 1 gemessen. Soweit Abweichungen von dieser Norm (beispielsweise bei der Probendicke) nicht zu vermeiden sind, wird in möglichst enger Anlehnung an die genannte Norm gemessen. Dazu wird das Silicium direkt nach der Kristallisation innerhalb weniger als 2 min von T > 1250°C auf T < 500°C abgeschreckt, falls dies nicht möglich oder sinnvoll ist wird das entsprechende Silicium für die Messung zunächst länger als 1 h auf eine Temperatur größer 1250°C gebracht und danach innerhalb von weniger als 2 min auf eine Temperatur kleiner als 500°C abgeschreckt.

Die Messung der Versetzungsdichte erfolgt nach dem im Folgenden geschilderten Verfahren:
Die Siliciummaterialproben werden zunächst auf einen PVC-Probenhalter mit einem Zweikomponentenkleber aufgeklebt und nach Abbinden des Klebers mit 400er SiC-Schleifpapier (Fa. Struers) plangeschliffen und abgespült. Danach wird stufenweise mit 800er, 1000er und 2400er Papier feingeschliffen und gespült, jeder Schleifvorgang dauert etwa 1 Minute. Als Wasch- und Spülflüssigkeit wird vollentsalztes Wasser verwendet. Anschließend werden die Proben mit Diamantflüssigkeit (3 µm) (Fa. Struers) auf dem entsprechenden Textiltuch geläppt. Der abschließende Poliervorgang findet auf einem Textiltuch statt, es wird 45%iges Kieselsol der BAYER AG (Handelsname Levasil 100®) verwendet. Poliert wird, bis die Oberfläche bei visueller Kontrolle glatt erscheint (Dauer 30 min bis 1 h).

Danach wird die Probe gründlich gespült und anschließend mit einer Kristalldefekte selektiv angreifenden Ätzlösung behandelt. Dabei wird die Probe in einer frisch bereiteten Lösung aus Kaliumdichromat und Flusssäure eine Minute lang unter ständigem kräftigen Rühren geätzt. Die Ätzlösung besteht aus 40 ml einer 45 %igen wässrigen Kaliumdichromatlösung und 60 ml 40 %iger Flusssäure. Durch die Ätzbehandlung bilden sich an den Stellen, an denen Versetzungslinien durch die Oberfläche stoßen, kleine Trichter, sogenannte Ätzgruben, die anschließend bildanalytisch ausgezählt werden.
Die Probenoberfläche wird dazu im Lichtmikroskop im Dunkelfeld bei 500facher Vergrößerung betrachtet. Das Bild wird über eine CCD-Kamera einem Bildverarbeitungssystem zugeführt. Hier wird das Bild in 768 x 512 Bildpunkten digitalisiert und gespeichert. Die Korngrenzen und Ätzgruben leuchten bei der gewählten Dunkelfeldbeleuchtung hell auf. Alle hellen Objekte mit einem Umfang zwischen 5 und 500 Bildpunkten (Pixel) und einem Ellipsenformfaktor von größer 0,3 (Verhältnis der großen Ellipsenachse zur kleinen Ellipsenachse) werden als Versetzungs-Ätzgruben interpretiert und gezählt, wobei Korngrenzen von der Zählung ausgeschlossen werden.

Das erfindungsgemäße Silicium kann nach den gängigen Methoden erhalten werden, die zur Erzeugung von Basismaterial von Solarzellen angewendet werden, sofern der hohe Sauerstoffgehalt und die hohe Versetzungsdichte über die oben genannten Maßnahmen eingestellt werden kann. Vorteilhafterweise kommen Folienzieh- und Foliengießverfahren zum Einsatz, vorzugsweise wird das erfindungsgemäße Silicium nach dem RGS-Verfahren hergestellt.

Das erfindungsgemäße Silicium kann vorteilhaft in der Photovoltaik eingesetzt werden. Es kann nach den üblichen, dem Fachmann bekannten Methoden p- oder n-dotiert werden. Das dotierte Silicium kann auf bekannte Weise als Ausgangsmaterial für Solarzellen Verwendung finden.

Die Dotierung des Siliciums erfolgt beispielsweise bei dessen Kristallisation. p-dotiertes Silicium wird beispielsweise durch Zugabe von Borverbindungen oder vorzugsweise durch Zugabe einer Bor-Silicium-Stammlegierung zur Siliciumschmelze oder zu dem aufzuschmelzenden Silicium erhalten. n-dotiertes Silicium wird beispielsweise durch Zugabe von Phosphorverbindungen oder vorzugsweise durch Zugabe einer Phosphor-Silicium-Stammlegierung zur Siliciumschmelze oder dem aufzuschmelzenden Silicium erhalten. n- oder p-dotiertes Silicium können auch durch entsprechende Zusammenstellung von Siliciumrohstoffen beziehungsweise Siliciumsekundärrohstoffen erhalten werden, die die gewünschte Gesamtdotierungsmenge beispielsweise an Bor oder Phosphor enthalten.

Aus dem p-dotierten Silicium mit dem erfindungsgemäß hohen Sauerstoffgehalt und der hohen Versetzungsdichte können beispielsweise n⁺p-Solarzellen hergestellt werden, das n-dotierte Silicium eignet sich als Ausgangsmaterial für p⁺n-Solarzellen. Wege, aus dotiertem Silicium Solarzellen zu prozessieren, sind Stand der Technik und dem Fachmann bekannt.

Das erfindungsgemäße Silicium eignet sich trotz des hohen Sauerstoffgehalts gut als Ausgangsmaterial für Solarzellen. Dabei kommt der hohen Versetzungsdichte im Silicium eine besondere Rolle zu. Wenn in dem Siliciummaterial eine hohe Sauerstoffkonzentration und eine hohe Versetzungsdichte vorhanden sind, dann kommt es während der Durchführung von Hochtemperaturschritten (vor oder während der Prozessierung der Solarzelle) zur Ausscheidung des Sauerstoffs in Form von Silicium-Sauerstoff-Aggregaten oder -Clustern vorzugsweise an den Versetzungen. Damit liegen die Sauerstoffausscheidungen nicht wie sonst üblich als isolierte Partikel vor, sondern sie sind als Ketten entlang der Versetzungen angeordnet. Wenn der Sauerstoffgehalt genügend hoch ist und genügend Sauerstoff ausgeschieden ist, dann sind diese Ausscheidungsketten durch die üblicherweise im Oxid eingefrorenen Oxidladungen positiv aufgeladen und bilden positiv geladene Filamente mit einem Durchmesser vorzugsweise zwischen 1 und 100 nm. Diese geladenen Präzipitat-Filamente wirken sich unterschiedlich aus, je nachdem ob die Solarzelle wie allgemein üblich aus p-leitendem Ausgangsmaterial gefertigt wird (n⁺p-Struktur), oder ob sie aus n-leitendem Ausgangsmaterial gefertigt wird (p⁺n-Struktur).

Bei einer n⁺p-Struktur befindet sich der größte Teil der Präzipitat-Filamente im p-leitenden Material der Basis der Zelle. Wenn die Oxidladung genügend groß ist, dann gerät die unmittelbare Umgebung der Filamente in Ladungsträger-Inversion, d.h. die Umgebung der Filamente wird n-leitend. Damit verringert sich ihre Rekombinationswirksamkeit für Elektronen erheblich, da keine Löcher als Rekombinationspartner mehr vorhanden sind, ebenso wie das bei der bekannten spontanen Oberflächen-Inversion unter einer oxidierten p-Silicium Oberfläche der Fall ist. Ebenso wie dort verhalten sich die Präzipitat-Filamente als Leiter für Minoritätsladungsträger (hier Elektronen) durch den Kristall. Da ein erheblicher Teil der Filamente durch den pn-Übergang stößt und dadurch elektrisch mit dem Emitter verbunden ist, können über die Filamente Minoritätsladungsträger aus der Tiefe der Basis heraus zu dem pn-Übergang an der Oberfläche fließen, wodurch die Stromeffizienz der Solarzelle erheblich verbessert wird. Der Effekt der Verwendung des erfindungsgemäßen Materials zur Herstellung von n⁺p-Solarzellen ist also der, dass die sich bei der Prozessierung bildenden Auscheidungsfilamente ein System leitfähiger Kanäle (n-leitende oder elektronenleitende Kanäle) bilden, die elektrisch mit dem Emitter verbunden sind und dadurch die Minoritätsträger besonders effektiv aus der Basis zum Emitter transportieren. Dadurch kann die Solarzelle bereits mit einer Minoritätsladungsträger-Diffusionslänge funktionieren, die klein gegen die Scheibendicke ist.

Wenn Solarzellen aus n-leitendem Ausgangsmaterial mit einem p-dotierten Emitter hergestellt werden (p⁺n-Struktur), dann wirken sich die bei der Prozessierung durch die Verwendung des erfindungsgemäßen Materials gebildeten positiv geladenen Sauerstoffausscheidungen folgendermaßen aus: Sie wirken auf die lichterzeugten Minoritätsladungsträger (hier Löcher) elektrostatisch abstoßend, aber auf Majoritätsladungsträger (Elektronen) anziehend. Es bilden sich also um die Filamente herum Anreicherungskanäle aus, die die Minoritätsladungsträger abstoßen. Dies ist der gleiche Effekt, der bei üblichen n⁺p-Solarzellen durch eine zusätzliche p⁺-Dotierung des Rückseitenkontaktes erreicht wird, und der als "Back Surface Field, BSF" bekannt ist. Auch dort wird die Rückseite der Zelle durch ein abstoßendes elektrisches Feld passiviert und damit rekombinationsinaktiv gemacht. Die Verwendung des erfindungsgemäßen Siliciums zur Herstellung von p⁺n-Solarzellen führt also dazu, dass die Versetzungen und auch andere Kristalidefekte durch die positiv geladenen Silicium-Sauerstoff-Ausscheidungen, die sich bei der Prozessierung bilden, effektiv passiviert werden, wodurch sich trotz der hohen Defektdichte eine genügend große Diffusionslänge der Ladungsträger im Silicium ergibt.

Der Vorteil des Einsatzes des erfindungsgemäßen Siliciums zur Fertigung von Solarzellen gegenüber dem bisher für Solarzellen verwendeten Siliciummaterial besteht darin, dass dieses Silicium besonders kostengünstig herstellbar ist, da man bei seiner Herstellung nicht auf die Einhaltung eines maximal erlaubten Sauerstoffgehaltes achten muss. Es ist einfacher, sauerstoffreiches als sauerstoffarmes Siliciummaterial zu erschmelzen. Ein weiterer Vorteil ist, dass das Material eine höhere Dichte von Kristalldefekten aufweisen darf, da diese Defekte im Falle des p-dotierten Siliciums bewusst zur Stromleitung verwendet werden und im Falle des n-dotierten Siliciums effektiv passiviert werden.

Die Herstellung des erfindungsgemäßen Siliciums, seine Verwendung in der Photovoltaik und die Herstellung und die Eigenschafen von Solarzellen, die auf diesem Silicium basieren werden anhand der folgenden Beispiele weiter erläutert. Die Beispiele stellen jedoch keine Einschränkung des Erfindungsgedankens dar, sondern illustrieren diesen nur.

### Beispiele

Als Ausführungsbeispiele für die Herstellung des erfindungsgemäßen Siliciummaterials zur Herstellung von Solarzellen werden im folgenden die Herstellung von p- bzw. n-leitenden Siliciumfolien nach dem RGS-Verfahren (Ribbon Growth on Substrate) gemäß EP 0 165 449 A1 und DE 41 05 910 A1 beschrieben.

### Beispiel 1:

300 g Silicium-Granalien wurden zusammen mit 1,2856 g einer Bor-Silicium-Stammlegierung mit 43 ppmg Bor in einem Quarzglastiegel aufgeschmolzen und dann in den Formkörper einer diskontinuierlich arbeitenden RGS-Anlage gegossen. Dann wurden die Graphit-Substratplatten der RGS-Anlage mit einer Geschwindigkeit von 6,5 m/min unter dem Gießrahmen entlangbewegt. Dabei wurde ein Begasungsstrom von 7,5 m³h , bestehend aus 67 Vol.% Sauerstoff und 33 Vol.% Argon hinter dem Formkörper über Oberfläche des erstarrenden Siliciums geleitet. Die so entstanden Siliciumfolien wurden mittels Kompensationsheizung zunächst 1 h auf ca. 1130°C gehalten, dann durch entsprechendes Herunterfahren der Heizung mit ca. - -50°C/h Steigung bis auf ca. 990°C und schließlich durch Abstellen der Heizung innerhalb von rund 2 h bis auf Raumtemperatur abgekühlt.
Per FTIR-Spektroskopie war in den Siliciumfolien ein Gehalt an interstitiellem Sauerstoff in Höhe von 1,4x10¹⁷ Atomen/cm³ zu messen. Gleichartig hergestellte Siliciumfolien die ohne die oben beschriebene Temperung innerhalb von 20 sec bis auf 500°C und dann innerhalb von 1 h bis auf Raumtemperatur abgekühlt werden zeigten einen entsprechenden Gehalt an interstitiellem Sauerstoff in Höhe von 2,6x10¹⁸ Atomen/cm³.

### Beispiel 2:

Man verfuhr wie in Beispiel 1, nur wurden 300 g Silicium-Sekundärrohstoff aus der Halbleiterindustrie mit einer Phosphor-Dotierung entsprechend einem Widerstand von 1 Ωcm eingesetzt.

Per FTIR-Spektroskopie war in den Siliciumfolien ein Gehalt an interstitiellem Sauerstoff in Höhe von 4,0x10¹⁷ Atomen/cm³ zu messen. Gleichartig hergestellte Siliciumfolien, die ohne die oben beschriebene Temperung innerhalb von 20 sec bis auf 500°C und dann innerhalb von 1 h bis auf Raumtemperatur abgekühlt wurden, zeigten einen entsprechenden Gehalt an interstitiellem Sauerstoff in Höhe von 2,2x10¹⁸ Atomen/cm³.

Als Ausführungsbeispiele für die Anwendung des erfindungsgemäßen Siliciummaterials zur Herstellung von Solarzellen werden im folgenden die Herstellung einer n⁺p- und einer p⁺n-Solarzelle aus p- bzw. n-leitendem Ausgangsmaterial beschrieben.

### Beispiel 3:

n⁺p-Solarzellen aus dem erfindungsgemäßen Silicium wurden mehrfach mit einer Größe von 2x2 cm² als Labormuster aufgebaut. Das p-leitende Ausgangsmaterial hatte eine Dotierung mit Bor von 10¹⁶ Atomen/cm³, eine Dicke von 350 µm und wies erfindungsgemäß einen Sauerstoffgehalt von 3,2x10¹⁸ Atomen/cm³ und eine mittlere Versetzungsdichte von etwa 5x10⁵ cm⁻² auf. Die Eindiffusion des Emitters erfolgte konventionell mit einem Phosphor-Diffusionsschritt bei 825°C für 1h in oxidierender Umgebung. Es wurde ein Rückseitenkontakt durch Aufdampfen des folgenden Schichtpaketes aufgebracht: 0.2 µm Al, 02 µm Ti, 0.02 µm Pd und 2 µm Ag. Anschließend wurde die so vorbehandelte Silicium-Scheibe für 30 min bei 625°C in einer Stickstoff-Wasserstoff-Atmosphäre getempert, um einen guten ohmschen Kontakt herzustellen. Ein Frontseiten-Kontaktgitter wurde durch Aufdampfen des folgenden Schichtpaketes hergestellt: 0.2 µm Ti, 0.02 µm Pd, 2 µm Ag. Eine Antireflexbeschichtung erfolgte nicht. Nach der Prozessierung sind die Versetzungen im Basismaterial der Zelle zu Ausscheidungs-Filamenten mit einem Durchmesser von größenordnungsmäßig 10 nm umgewandelt worden, wie transmissionselektronenmikroskopische Untersuchungen gezeigt haben. Der Kurzschlußstrom der Solarzellen wies mit 18.55 mA/cm² einen für ein Material mit dieser Defektdichte erstaunlich hohen Wert auf, was problemlos mit der erfindungsgemäßen Ausbildung der Inversions-Leitungskanäle (n-leitenden Kanäle) um die Ausscheidungsfilamente herum erklärt werden kann. Der Kurzschlussstrom einer im gleichen Arbeitsgang prozessierten Scheibe aus monokristallinem Czochralski-Si, einem besonders hochwertigen Material für die Photovoltaik, betrug nur 18.21 mA/cm².

### Beispiel 4:

p⁺n-n⁺-Solarzellen sind ausgehend von n-leitendem Silicium erhältlich. Das n-leitende Ausgangsmaterial wies eine Dotierung mit Phosphor von 10¹⁶ Atomen/cm³ P und erfindungsgemäß einen Sauerstoffgehalt von 3,2x10¹⁸ Atomen/cm³ und eine mittlere Versetzungsdichte von etwa 5x10⁵ cm⁻² auf. Der p-dotierte Emitter wurde durch eine Aluminium-Eindiffusion erzeugt, und durch eine Phosphordiffusion an der Rückseite wurde ein Rückseitenfeld (Back-Surface-Field, BSF) erzeugt. Der Rückseitenkontakt bestand beispielsweise aus einem Schichtsystem aus 0.2 µm Ti, 0.02 µm Pd, 2 µm Ag und das Frontseiten-Kontaktgitter wurde durch Aufbringen einer Al-Schicht erzeugt. Durch die erfindungsgemäße Verwendung von sehr sauerstoffreichem Ausgangsmaterial waren die Kristalldefekte in der Basis passiviert und trugen nicht oder nur wenig zur Verringerung der Diffusionslänge des Materials bei.

Alternativ kann der Emitter beispielsweise auch durch die Eindiffusion von Bor erzeugt werden.

## Patentansprüche

1. Silicium, dadurch gekennzeichnet, dass es einen Gesamtsauerstoffgehalt von 8x10¹⁷ Atomen/cm³ bis 1x10¹⁹ Atomen/cm³ und eine Dichte an Versetzungen von 1x10⁵ cm² bis 5x10⁷ cm⁻² aufweist.

2. Silicium gemäß Anspruch 1, dadurch gekennzeichnet, dass der darin enthaltene Sauerstoff zu mindestens 25 % in Form von Silicium-Sauerstoff-Ausscheidungen vorliegt.

3. Silicium gemäß mindestens einem der Ansprüche 1 bis 2, dadurch gekennzeichnet, dass die Silicium-Sauerstoff-Ausscheidungen im Bereich der Korngrenzen und Versetzungen angereichert sind.

4. Silicium gemäß mindestens einem der Ansprüche 1 bis 3, dadurch gekennzeichnet, dass das Silicium p-dotiert ist.

5. Silicium gemäß mindestens einem der Ansprüche 1 bis 3, dadurch gekennzeichnet, dass das Silicium n-dotiert ist.

6. Verfahren zur Herstellung von Silicium mit einem Gesamtsauerstoffgehalt von 8x10¹⁷ Atomen/cm³ bis 1x10¹⁹ Atomen/cm³ und einer Dichte an Versetzungen von 1x10⁵ cm⁻² bis 5x10⁷ cm⁻², dadurch gekennzeichnet, dass geschmolzenes Silicium sich im Kontakt mit Siliciummonoxid und/oder Siliciumdioxid weitgehend mit Sauerstoff sättigen kann und/oder die Siliciumschmelze vor oder während der Kristallisation mit einem sauerstoffhaltigen Gas behandelt wird, und dass weiterhin die Dichte an Versetzungen über die Abkühlungsgeschwindigkeit des Siliciums eingestellt wird.

7. Verfahren zur Herstellung von Silicium mit einem Gesamtsauerstoffgehalt von 8x10¹⁷ Atomen/cm³ bis 1x10¹⁹ Atomen/cm³ und einer Dichte an Versetzungen von 1x10⁵ cm⁻² bis 5x10⁷ cm⁻², wobei der vorhandene Sauerstoff zu mindestens 25 % in Form von Silicium-Sauerstoff-Ausscheidungen vorliegt, die im Bereich der Korngrenzen und Versetzungen angereichert sind, dadurch gekennzeichnet, dass geschmolzenes Silicium sich im Kontakt mit Siliciummonoxid und/oder Siliciumdioxid weitgehend mit Sauerstoff sättigen kann und/oder die Siliciumschmelze vor oder während der Kristallisation mit einem sauerstoffhaltigen Gas behandelt wird, dass weiterhin die Dichte an Versetzungen über die Abkühlungsgeschwindigkeit des Siliciums eingestellt wird und dass der Anteil von Silicium-Sauerstoff-Ausscheidungen am Gesamtsauerstoffgehalt und dessen Anreicherung an den Korngrenzen und Versetzungen durch thermische Behandlung des Siliciums erreicht wird.

8. Verfahren gemäß Anspruch 7, dadurch gekennzeichnet, dass das Silicium für einen Zeitraum von 1 Minute bis 10 Stunden auf eine Temperatur von 500°C bis 1250°C gebracht wird, wobei die Temperatur im angegebenen Bereich konstant gehalten oder variiert werden kann, jedoch mindestens 1 Minute 950°C übersteigen muss.

9. Verfahren gemäß mindestens einem der Ansprüche 7 bis 8, dadurch gekennzeichnet, dass das Silicium für einen Zeitraum von 1 Minute bis 10 Stunden auf eine Temperatur von 800°C bis 1150°C gebracht wird, wobei die Temperatur im angegebenen Bereich konstant gehalten oder variiert werden kann, jedoch mindestens 1 Minute 950°C übersteigen muss.

10. Verfahren gemäß mindestens einem der Ansprüche 7 bis 9, dadurch gekennzeichnet, dass das Silicium nach einem Folienzieh- oder -gießverfahren hergestellt wird.

11. Verfahren gemäß mindestens einem der Ansprüche 7 bis 10, dadurch gekennzeichnet, dass das Silicium nach dem RGS-Verfahren hergestellt wird.

12. Verwendung von Silicium nach einem der Ansprüche 1 bis 5 in der Photovoltaik.

13. Solarzellen, enthaltend Silicium nach einem der Ansprüche 1 bis 5.

14. n⁺p-Solarzellen, dadurch gekennzeichnet, dass sie p-dotiertes Silicium nach Anspruch 4 enthalten.

15. p⁺n-Solarzellen, dadurch gekennzeichnet, dass sie n-dotiertes Silicium nach Anspruch 5 enthalten.
